# EUROPEAN PATENT APPLICATION

(11) **EP 1 705 550 A2**
(43) Date of publication of application: **27.09.2006**
(21) Application number: 06075600.4
(22) Date of filing: 14.03.2006
(51) Int. Cl.: G06F 1/20, H05K 7/20

(54) **Integral liquid cooling unit for a computer**

(30) Priority: 24.03.2005 US 88414
(71) Applicant: Delphi Technologies, Inc., Troy, MI 48007 (US)
(72) Inventor: Wintersteen, Douglas C., Burt, NY 14028 (US); Corser, Don C., Lockport, NY 14094 (US)
(74) Representative: Denton, Michael John

(57) **Abstract**

An integral liquid cooling unit for an electronic device comprises a manifold (20) defining a plurality of heat sink compartments (22) for heat exchange engagement with the electronic device. The manifold (20) presents a platform (24) for sealing engagement with a pump (26). The manifold (20) also presents an inlet (30) and an outlet (32) and defines internal passages (28) establishing fluid communication between the pump (26) and the inlet (30) and outlet (32) through the heat sink compartments (22). A heat exchanger (34) is mounted directly to the manifold (20) and in fluid communication with the inlet (30) and outlet (32) of the manifold (20). More specifically, the heat exchanger (34) includes a first tank (36) and a second tank (38) each defined by a cylindrical tube with an open lower end of the first tank (36) extending into and in sealed engagement with the inlet (30) in the manifold (20) and an open lower end of the second tank (38) extending into and in sealed engagement with the outlet (32) in the manifold (20).

## Description

### TECHNICAL FIELD

An integral liquid cooling unit for an electronic device.

### BACKGROUND OF THE INVENTION

Many electronic systems produce heat that is detrimental to the electronic system and must be dissipated. Accordingly, a wide variety of heat sinks have been developed for extracting and dissipating such heat. As illustrated in U.S. Patents 3,361,195 to Meyerhoff et al and 6,257,320 to Wargo, such systems may include a manifold defining a heat sink compartment presenting an outer surface for heat exchange engagement with an electronic device. Still further, the manifold may present a pump-platform for sealing engagement with a pump with the manifold presenting an inlet and an outlet in fluid communication with the pump through internal passages in the manifold, as illustrated in U.S. Patent Application Publication No. 2002/0039280 A1 of April 4, 2002 in the name of O'Conner et al.

A major concern in developing such cooling systems is to avoid the potential for leakage of the cooling fluid. The use of hoses or flexible conduits to interconnect the components increases the potential for leakage at the connections. In addition, such flexible hoses or conduits are susceptible to wear and leakage from rupture under pressure. The potential for leakage is increased because of the difficulty of assembly or connections of such hoses and conduits, let alone the labor and time costs of such assembly. It is also frequently difficult to match compatible materials in the hoses and conduits with the coolant fluid and/or environmental extremes to which such systems are subjected.

### SUMMARY OF THE INVENTION

The subject invention provides an integral liquid cooling unit for an electronic device wherein a heat exchanger is mounted to a manifold so as to be in fluid communication with the inlet and outlet and internal passages of the manifold.

Accordingly, the subject invention decreases the risk of leakage and the resultant coolant loss.

### BRIEF DESCRIPTION OF THE DRAWINGS

Other advantages of the present invention will be readily appreciated, as the same becomes better understood by reference to the following detailed description when considered in connection with the accompanying drawings wherein:
Figure 1 is a perspective view of an embodiment of the manifold of the subject invention made of top and bottom plates;
Figure 2 is a fragmentary cross sectional view of a manifold of the subject invention;
Figure 3 is another view like Figure 2 but showing a variation of the manifold construction; and
Figure 4 is a plan view of an embodiment of the manifold of the subject invention made of one solid block.

### DESCRIPTION OF THE PREFERRED EMBODIMENT

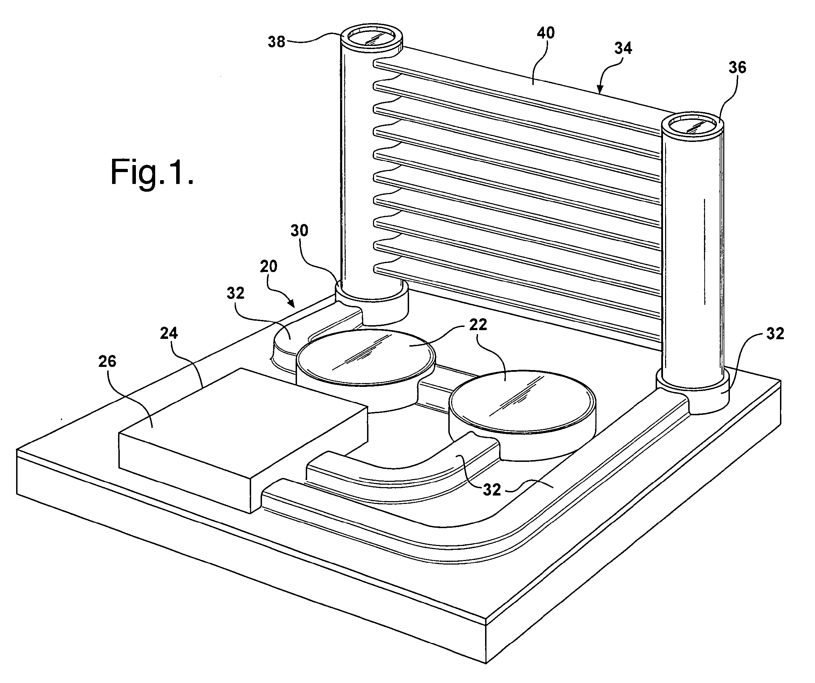

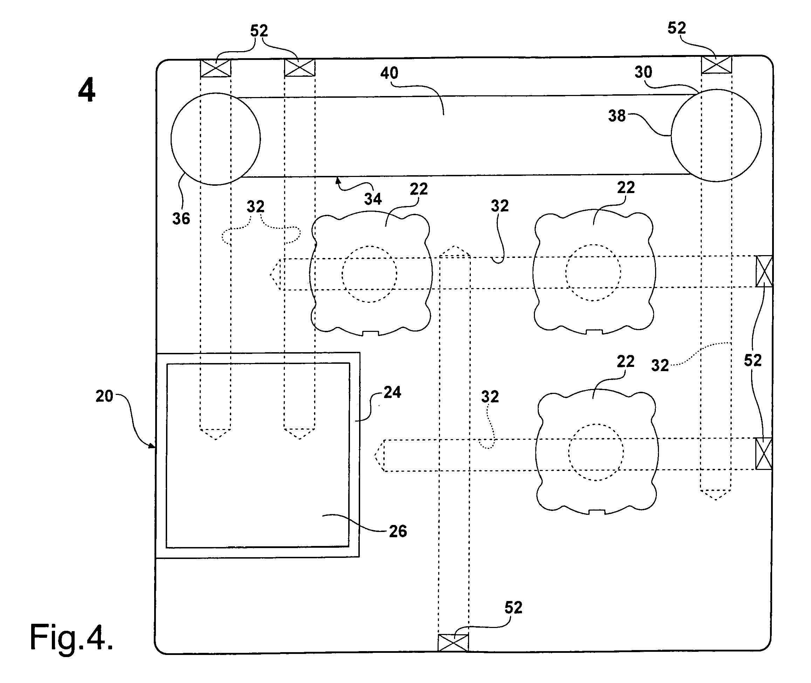

An integral liquid cooling unit for an electronic device constructed in accordance with the subject invention is shown in Figures 1 and 4.

The unit is fabricated about a manifold, generally indicated at **20,** defining a plurality of heat sink compartments **22** each presenting an outer surface for heat exchange engagement with an electronic device (not shown).

The manifold **20** presents a platform **24** for sealing engagement with a pump **26.** The pump **26** is secured to and supported by the manifold **20** in sealing engagement with the platform **24.** The pump **26** may be secured by fasteners, or the like, with seals, gaskets, O-rings, or the like, sealing the pump **26** to the platform **24.** The pump **26** includes ports in direct sealed engagement with openings into the internal passages **28** in the manifold **20.**

The manifold **20** also presents an inlet **30** and an outlet **32** and defines internal passages **28** establishing fluid communication between the pump **26** and the inlet **30** and outlet **32** through the heat sink compartments **22.**

A heat exchanger, generally indicated at **34,** is mounted to the manifold **20** and in fluid communication with the inlet **30** and outlet **32** of the manifold **20.** More specifically, the heat exchanger **34** includes a first tank **36** and a second tank **38** spaced from the first tank **36** with a core **40** extending between the tanks **36, 38** for conducting fluid flow between the tanks **36, 38** while extracting heat, the core **40** being of the well known type including tubular elements for conducting fluid between the tanks **36, 38** with fins between the fluid conveying elements to exchange heat with air flowing through the fluid conveying elements. Each tank **36, 38** is defined by a cylindrical tube with an open lower end of the first tank **36** extending into the inlet **30** in the manifold **20** and an open lower end of the second tank **38** extending into the outlet **32** in the manifold **20.** The top end of each of the tanks **36, 38** is capped or other wise sealed whereby fluid enters the first tank **36** from the pump **26** through the internal passages **28** and passes through the core **40** to the second tank **38** and back into the internal passages **28** and to the heat sink compartments **22.** The first tank **36** is supported in sealed engagement with the inlet **30** and the second tank **38** is supported in sealed engagement with the outlet **32.** This may accomplished by the manifold **20** and tanks **36, 38** being metal with the tanks **36, 38** brazed (welded) in the inlet **30** and outlet **32.** Alternatively, the tanks **36, 38** may be attached to the manifold **20** by fasteners with O-rings, gaskets, seals, or the like, sealing the tanks **36, 38** to the inlet **30** and outlet **32.** The manifold **20** is disposed in a plane containing the horizontal X and Y axes and thereby extends along at least one horizontal axis and the tanks **36, 38** extend along a vertical Z axis that is transverse to the axis (X or Y) of the manifold **20.** The manifold **20** a bottom surface and a top surface extending laterally of the horizontal axis X or Y.

The outer surface of the heat sink compartment **22** is disposed in one of the top and bottom surfaces of the manifold **20** whereas the platform **24** for the pump **26** is disposed on the top surface. The internal passages **28** extend through the interior of the manifold **20** and are spaced from and between the top and bottom surfaces thereof.

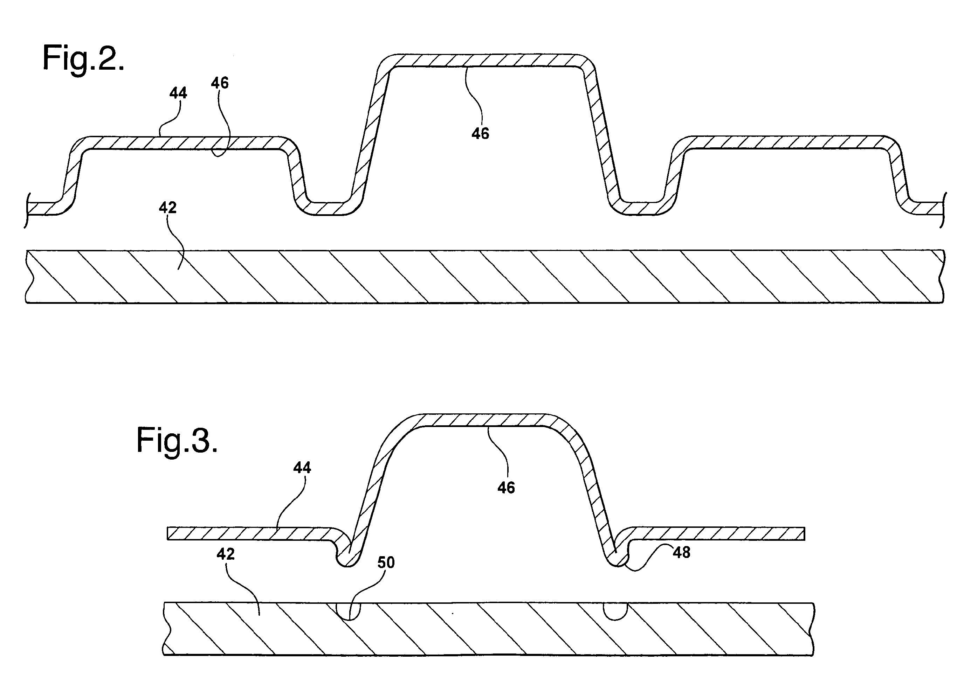

As illustrated in Figures 1, 2 and 3, the manifold **20** comprises a bottom plate **42** and a top plate **44** in sealed engagement with the bottom plate **42.** The bottom plate **42** is rigid and the top plate **44** of the 2-piece manifold may or may not be of less thickness than the bottom plate **42,** i.e., the top plate **44** may be a stamping made in a press to present grooves **46** defining the internal passages **28.** As shown in Figure 2, the bottom plate **42** presents a smooth or flat upper surface and the top plate **44** presents the grooves **46** open to and sealed by the upper surface of the bottom plate **42.** The top plate **44** may be sealed to the bottom plate **42** by gaskets or the metals thereof may be brazed together. In addition, as illustrated in Figure 3, the top plate **44** may include ribs **48** along the internal passages **28** for engaging a complimentary rut **50** in the bottom plate **42.** on the other hand, the manifold **20** may be a solid block of homogenous material, as illustrated in Figure 4. when a solid block of material, the passages **28** are drilled on different levels between the top and bottom surfaces and are plugged by plugs **52.**

Obviously, many modifications and variations of the present invention are possible in light of the above teachings. The invention may be practiced otherwise than as specifically described within the scope of the appended claims.

## Claims

1. An integral liquid cooling unit for an electronic device comprising;
a manifold **(20)** defining at least one heat sink compartment **(22)** presenting an outer surface for heat exchange engagement with an electronic device,
said manifold **(20)** presenting a platform **(24)** for sealing engagement with a pump **(26),**
said manifold **(20)** presenting an inlet **(30)** and an outlet **(32),**
said manifold **(20)** defining internal passages **(28)** establishing fluid communication between said pump **(26)** and said inlet **(30)** and outlet **(32)** through said heat sink compartment **(22),** and
a heat exchanger **(34)** mounted to said manifold **(20)** and in fluid communication with said inlet **(30)** and outlet **(32)** of said manifold **(20).**

2. An integral liquid cooling unit as set forth in claim 1 wherein said heat exchanger **(34)** includes a first tank **(36)** and a second tank **(38)** spaced from said first tank **(36)** with a core **(40)** extending between said tanks **(36, 38)** for conducting fluid flow between said tanks **(36, 38)** while extracting heat.

3. An integral liquid cooling unit as set forth in claim 2 wherein said first tank **(36)** is supported in sealed engagement with said inlet **(30)** and said second tank **(38)** is supported in sealed engagement with said outlet **(32).**

4. An integral liquid cooling unit as set forth in claim 3 wherein each of said tanks **(36, 38)** is defined by a tube with the end of said first tank **(36)** extending into said inlet **(30)** and said second tank **(38)** extending into said outlet **(32).**

5. An integral liquid cooling unit as set forth in claim 3 wherein said manifold **(20)** extends along an axis and said tanks **(36, 38)** extend transversely to said axis of said manifold **(20).**

6. An integral liquid cooling unit as set forth in claim 3 wherein said mounting plate **(42, 44)** and said tanks **(36, 38)** comprise metal and said tanks **(36, 38)** are welded to said manifold **(20).**

7. An integral liquid cooling unit as set forth in claim 3 wherein said manifold **(20)** extends along an axis and presents a bottom surface and a top surface extending laterally of said axis.

8. An integral liquid cooling unit as set forth in claim 7 wherein said outer surface of said heat sink compartment **(22)** is disposed in one of said top and bottom surfaces.

9. An integral liquid cooling unit as set forth in claim 8 wherein said platform **(24)** is disposed on said top surface.

10. An integral liquid cooling unit as set forth in claim 9 wherein said internal passages **(28)** extend through said manifold **(20)** and spaced from and between said top and bottom surfaces thereof.

11. An integral liquid cooling unit as set forth in claim 10 wherein said manifold **(20)** is a solid homogenous material.

12. An integral liquid cooling unit as set forth in claim 10 wherein said manifold **(20)** comprises a bottom plate **(42)** and a top plate **(44)** in sealed engagement with said bottom plate **(42).**

13. An integral liquid cooling unit as set forth in claim 12 wherein said bottom plate **(42)** is rigid and said top plate **(44)** is a sheet of less thickness than said bottom plate **(42).**

14. An integral liquid cooling unit as set forth in claim 13 wherein said top plate **(44)** defines said internal passages **(28).**

15. An integral liquid cooling unit as set forth in claim 14 wherein said bottom plate **(42)** presents a smooth upper surface and said top plate **(44)** presents grooves **(46)** open to and sealed by said upper surface of said bottom plate **(42).**

16. An integral liquid cooling unit as set forth in claim 3 including a pump **(26)** secured to and supported by said manifold **(20)** in sealing engagement with said pump **(26)** -platform **(24).**

17. An integral liquid cooling unit as set forth in claim 16 wherein said pump **(26)** includes an inlet **(30)** port and an outlet **(32)** port in direct sealed engagement with openings into said internal passages **(28)** in said manifold **(20).**
